# EUROPEAN PATENT SPECIFICATION

(11) **EP 0 663 690 B1**
(45) Date of publication and mention of the grant of the patent: **03.12.2003**
(21) Application number: 95103878.5
(22) Date of filing: 07.06.1989
(51) Int. Cl.: H01L 21/311, G03F 7/42

(54) **An ashing method for removing an organic film on a substance of a semiconductor device under fabrication**
Veraschungsverfahren zum Entfernen einer organischen Schicht auf einer Halbleiteranordnung während ihrer Herstellung
Enlèvement d'une couche organique sur un dispositif semi-conducteur pendant sa fabrication par réduction en cendres

(30) Priority: 09.06.1988 JP 14267388
(43) Date of publication of application: 19.07.1995
(62) Divisional of application: 89110295.6
(73) Proprietor: FUJITSU LIMITED, Kawasaki-shi, Kanagawa 211 (JP)
(72) Inventor: Shinagawa, Keisuke, Tokyo 152 (JP); Fujimura, Shuzo, Towa Cityco-op, Edogawa-ku, Tokyo, 133 (JP); Hikazutani, Kenichi, Kuwana-shi, MIE,511 (JP)
(74) Representative: Schmidt-Evers, Jürgen, Dipl.-Ing.

(56) References cited:
- US-A- 3 837 856
- US-A- 4 673 456
- US-A- 4 689 112
- US-A- 4 699 689

## Description

### BACKGROUND OF THE INVENTION

### (1) Field of The Invention

The present invention relates to a removing method of an organic material used in a semiconductor device, and particularly the present invention relates to an ashing method of an organic film temporarily formed on a substance of a semiconductor device under fabrication.

An organic film such as a resist or a polyimide film temporarily formed on a substance, which is a part of a semiconductor device, for fabricating the semiconductor device was usually removed by an ashing method using oxygen plasma. Removing the resist film is an important process in fabrication of the semiconductor device, removing the resist film as an organic film will be described, hereinafter. Since the semiconductor device becomes very small as a Large Scale Integration circuit device (LSI) or a Very Large Scale Integrated circuit device (VLSI), the resist film, which will be called simply the "resist" hereinafter, becomes hard to be removed by the usual ashing method using the oxygen plasma without damaging the devices. Because, the property of the resist is changed during the process of ion implantation and dry etching, which are widely performed in the fabricating process of the LSI or the VLSI, so that a long time is required for performing ashing, in other words, the ashing rate of the resist becomes small. Since the resist is used many times in the fabrication process of the LSI or the VLSI, the ashing rate for each resist should be large to improve the throughput of the fabrication of the LSI or the VLSI.

A layer, called simply a "ground layer" hereinafter and the resist is formed thereon, is usually made of material such as silicon dioxide (SiO₂), polysilicon (Si) or aluminum (Al). Generally, the resist is not easy to be etched intentionally by the the ashing method, in other words, the resist is hard to be etched precisely so as to be removed only the resist without damaging any of the ground layer in the ashing process. Therefore, when the ashing method is applied to the fabricating process of the LSI or the VLSI, great attention must be paid to leave the ground layer as it is. Because, the ground layer of the LSI or the VLSI is very thin and any little part of it is not allowed to be etched.

There are many kinds of plasma ashing methods for removing the resist film provided on a insulating layer in a semiconductor device, however above all a down-flow ashing method is widely used. Because, applying the down-flow ashing method to the plasma ashing process, damage caused by charged particles can be avoided producing. The down stream ashing rate generally depends on a temperature, which will be called an "ashing temperature" hereinafter, of the resist so that the ashing rate decreases with the decrease of the ashing temperature. The ashing rate is usually expressed by the well known Arrhenius plot by which the ashing rates are plotted in a line against the inverse numbers of the respective ashing temperatures. In the Arrhenius plot, the gradient of the line gives the activation energy for ashing in such that when the ashing rate decreases rapidly with the decrease of the ashing temperature, the activation energy is large, and when the ashing rate changes only little with the decrease of the ashing temperature, the activation energy is small. On this, the small activation energy is desirable because the ashing can be performed almost independently on the ashing temperature, in other words, the ashing can be performed in stable and precisely.

Recently, there is a tendency that a wafer process in the fabrication process of a semiconductor device is performed at a lower temperature according as the semiconductor device has a higher integration circuit as seen in the LSI or the VLSI. The ashing process is desired to be performed lower than 300°C, most preferably lower than 200°C to avoid contamination from the resist. In order to maintain a large ashing rate at a low temperature, larger than 0.5 µ /min for practical use, the activation energy of the ashing rate must be also small. The activation energy of the ashing rate can be changed to some extent by changing the species of reactant gases used for ashing. The selection and the combination of the reactant gases are very important for making the ashing rate high and the activation energy small and for etching the resist precisely, leaving the ground layer as perfectly as possible and for minimizing damage. The selection and the combination of the reactant gases has been studied energetically.

### (2) Description of The Related Art

The downstream ashing is performed in a downstream of a microwave plasma using a microwave plasma resist stripper. This is fully disclosed in the paper titled "Heavy Metal Contamination From Resists during Plasma Stripping" by Shuzo Fujimura and Hiroshi Yano, in Elect. Chem. Soc. Vol. 135, No. 5, May 1988..

The downstream of a microwave plasma resist stripper consists of a vacuum chamber including a plasma generating chamber, a vacuum pump for exhausting gas in the vacuum chamber, a process chamber including a pedestal on which a sample wafer is placed and a microwave power source. A reactant gas is supplied to the process chamber through the plasma generating chamber.

Then, a reactant gas plasma is generated in the plasma generating chamber by the microwaves, so that active species for ashing produced in the gas plasma flows down to the process chamber and reacts with a resist previously formed on the sample wafer so as to remove the resist.

In the down stream ashing process, oxygen has been used as the reactant gas for a long time as described before. However, when only oxygen is used, the ashing rate is small and the activation energy is large, so that the down stream ashing using only oxygen was hard to be applied to the fabricating process of the LSI or the VLSI. Therefore, many other reactant gases have been studied for increasing the ashing rate and decreasing the activation energy, by adding other kinds of gases to the oxygen. As a result, several kinds of effective reactant gases have been found as will be described below, giving four examples, a first, a second, a third and a fourth examples, tracing the development of the reactant gases. The ashing rate and the activation energy are related to removing the resist film provided in a semiconductor device by plasma ashing method, hereinafter.

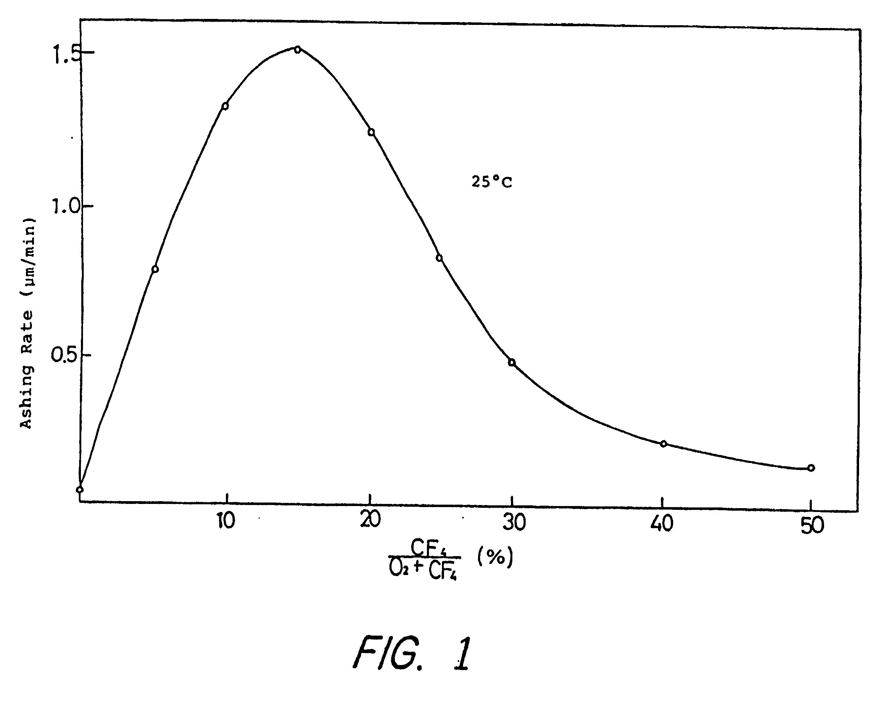

A first reactant gas was a mixed gas of oxygen (O₂) with a halogenide gas such as tetrafluoromethane (CF₄). The first reactant gas was most commonly used because it had a large ashing rate. Fig. 1 shows the ashing rate for commercially available photoresist(OFPR-800, TOKYO-OHKA) plotted against the variation of flow ratio of tetrafluoromethane to the mixed gas at room temperature. The ashing rate in the case using a reactant gas is simply called the ashing rate with the reactant gas, hereinafter. In Fig. 1, when tetrafluoromethane is added to oxygen as much as about 15% in the flow ratio, the ashing rate reaches a maximum value, 1.5 µm/min at 25°C, being large enough for practical use. However, the ground layer such as SiO₂, polysilicon (Si) or Al is etched because of fluorine (F) mixed in the first reactant gas. On the other hand, when the first reactnat gas is used, the activation energy is drastically reduced to a value of 0.1 eV from 0.52 eV which is the activation energy with only oxygen. Such large decrease of the activation energy is due to the tetrafluoromethane, which was explained in the paper, J.J.Hannon and J.M.Cook, J. Electrochem. Soc., Vol. 131, No. 5, pp 1164 (1984).

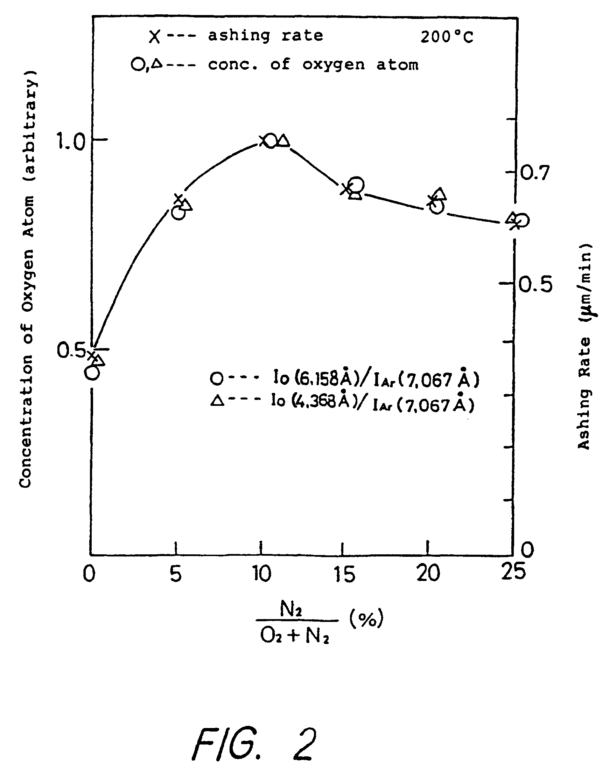

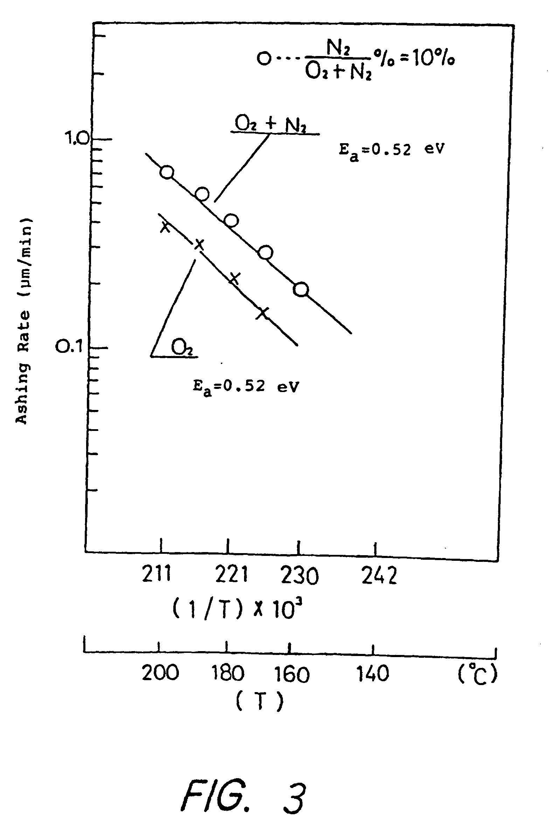

A second reactant gas was a mixed gas of oxygen and nitrogen (N₂), not containing fluorine (F), which did not etch the ground layer. The ashing rate and the concentration of oxygen atom in a down-flowed gas were measured by varying the flow ratio of nitrogen to the second reactant gas as shown in Fig. 2; wherein, the concentration of oxygen atom was measured by an actinometry method. In this case, the ashing temperature was 200°C and the flow rate of the second reactant gas was 1000 Standard Cubic Centimeter per Minute (SCCM). In Fig. 2, white circles represent the concentrations of oxygen atom, obtained from the spectral intensity ratio of the radiation from an oxygen atom (at a wavelength of 6158 Å) to the radiation from an argon atom (at a wavelength of 7067 Å) and triangles represent the concentrations of the same oxygen atom, obtained from the spectral intensity ratio of the radiation from an oxygen atom (at a wave length of 4368 Å) to the radiation from an argon atom (at a wavelength of 7067 Å). Further, the values of these concentrations are normalized by a maximum of the values of the concentrations, positioned at about 10% of the flow ratio of nitrogen to the second reactant gas. Multiplication signs represent the ashing rates to the flow ratio of nitrogen to the second reactant gas. As can be seen from Fig. 2, the curve of the ashing rate and that of the the concentration of oxygen atom are coincided each other, which means that oxygen atoms are only effective in performing the ashing. Fig. 3 shows the Arrhenius plot of the ashing rate when the second reactant gas contains 90% of oxygen and 10% of nitrogen in the flow ratio and the Arrhenius plot of the oxygen gas only. The ashing temperature is denoted by T. The ashing rate of the second reactant gas is plotted by a circle and the ashing rate of the oxygen is plotted by a multiplication sign. The ashing rate with the second reactant gas is about two times of that of oxygen only. The activation energy of ashing in the case using a reactant gas is simply called the activation energy of the reactant gas, hereinafter. The activation energy (Ea) of the second reactive gas, and that of the oxygen are equally 0.52 eV. That is, the activation energy does not change by mixing nitrogen. The ashing rate of the second reactive gas of 0.2 µm/min at 160 °C is too small for practical use. In order to increase the ashing rate, another kind of gas was needed.

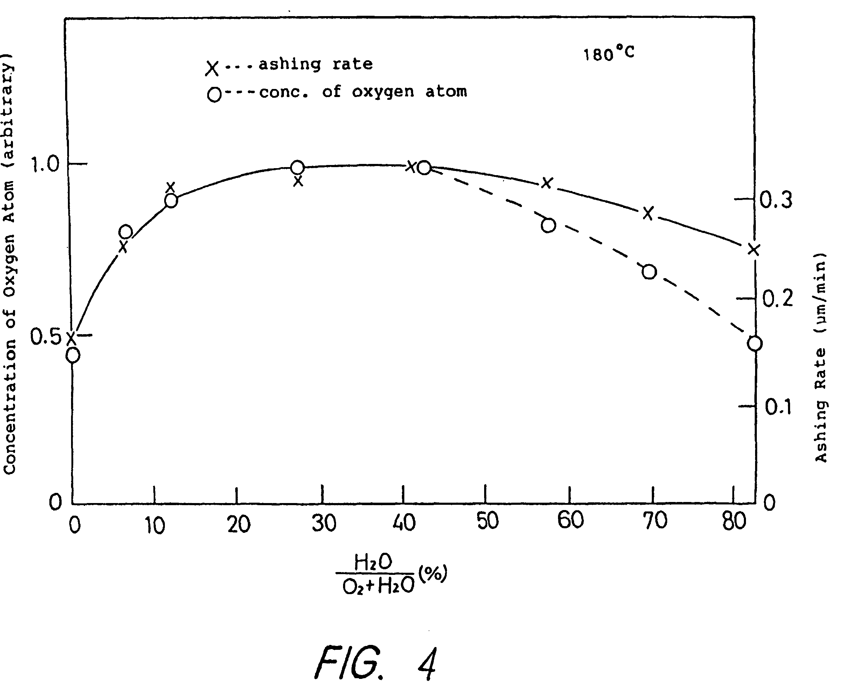

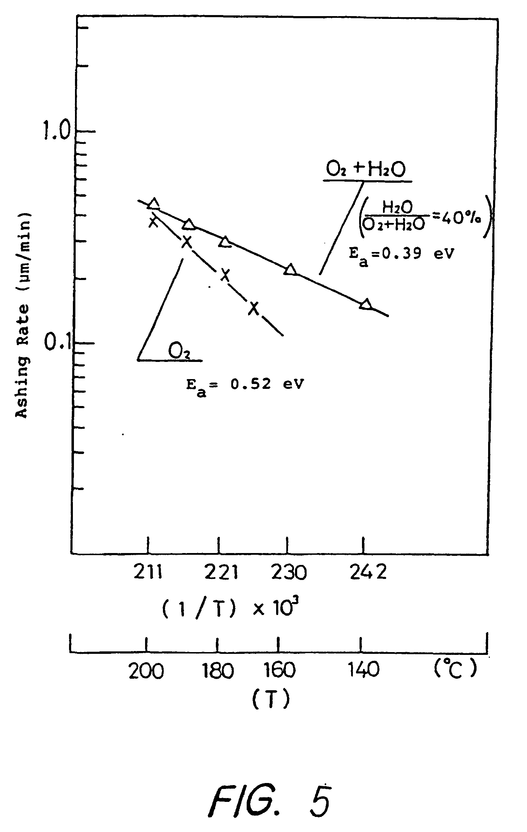

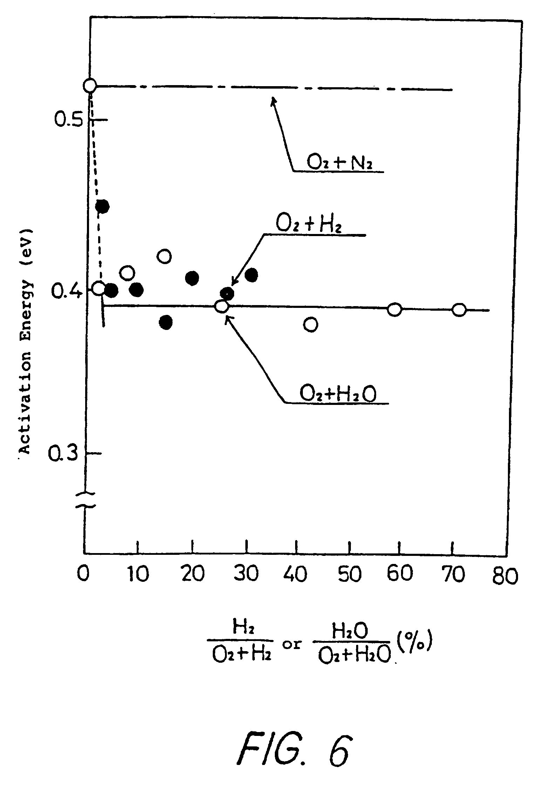

The third reactant gas was a mixed gas of oxygen and water vapor (H₂O) which did not etch the ground layer. The ashing rate and concentration of oxygen atom were measured by varying the flow ratios of water vapor to the third reactant gas as shown in Fig. 4. The measurements were performed under 180°C ashing temperature and 1000 SCCM flow rate of the third reactant gas. Circles and multiplication signs in Fig. 4 represent the same as in Fig. 2 respectively. When the flow ratio of water vapor to the third reactant gas exceeds 40%, the concentration of the oxygen atom decreases with the increase of the water vapor flow ratio. However, the ashing rate does not decrease so much as the decrease of the concentration of oxygen atom as seen in Fig. 4. This means that some active species except oxygen atoms are possible to take part in the ashing. Fig. 5 compares the Arrhenius plot of the third reactant gas containing 60% of oxygen and 40% of water vapor and Arrhenius plot of the oxygen gas. The ashing rate of the third reactant gas having 40% flow ratio of water vapor is plotted by triangles and the ashing rate of the oxygen is plotted by multiplication signs. The activation energy of the third reactive gas is 0.39 eV which is about three quarter of the activation energy (0.52 eV) of oxygen as shown in Fig. 6. Fig. 6 shows the activation energy of the ashing in the case using the third reactant gas by varying the flow ratios of water vapor to the third reactant gas, by white circles. In Fig. 6, the activation energy of ashing in the case using the mixed gas of oxygen and hydrogen by varying the flow ratio of hydrogen to the mixed gas is shown by solid circles, for the sake of comparison. It is seen in Fig. 6 that the activation energy is easily reduced by adding water vapor a little and the activation energy is constant independently on the flow ratio of water vapor when the flow ratio of water vapor exceeds 5%. The activation energy of the second reactant gas is also indicated by a dot chain line in Fig. 6 for the comparison with the third reactant gas. It is seen from this comparison that the activation energy does not change by adding nitrogen to oxygen. The behavior similar to the mixed gas of oxygen and water vapor is seen for the mixed gas of oxygen and hydrogen. On the other hand, the ashing rate of the third reactant gas is about o.22 µm/min at 160°C, as seen in Fig. 5. In conclusion, the value of the ashing rate of the third reactant gas is still too small for practical use.

The fourth reactant gas is a mixed gas of oxygen, nitrogen and tetrafluoromethane. The fourth reactant gas is disclosed in the Japanese laid-open patent application, SHO 63-102232, titled "DRY ETCHING APPARATUS" by Mikio Nonaka. When the flow ratio of tetrafluoromethane and nitrogen are in the range of 5 to 20% and 5 to 10% respectively, the large ratio of a rate of etching a positive resist to a rate of etching a ground layer is obtained without decreasing the ashing rate. However, the etching of ground layer can not be avoided occurring in this case.

A mixed gas made by adding as little as 0.2% of hydrogen to a mixed gas of oxygen, nitrogen and tetrafluoromethane is commercially available from EMERGENT TECHNOLGIES CO.(Phoenix 2320 NORD Photoresist Stripper). In this case, the hydrogen diluted by nitrogen is added in order to improve matching with microwave power. That is, the adding hydrogen to the mixed gas is not for reduction of the activation energy. So, the mixed gas is essentially the same as the first reactant gas. In fact, it is also known that the activation energy of the second reactant gas mixed with hydrogen does not decrease until up to 0.5% of hydrogen. US Patent 4 699 689 discloses a mixed gas comprising oxygen, hydrogen and an additional gas as reactant gas for ashing organic material formed on a ground substance of a semiconductor device.

As seen from the description of the first, second, third and fourth reactant gases, an ideal mixed gas, having a large ashing rate and small activation energy and never etching the ground layer, has not been found although much has been studied on new reactant gases.

### SUMMARY OF THE INVENTION

Accordingly, an object of the present invention is to improve the ashing process for removing the organic film formed on the ground layer of the semiconductor device under fabrication, so that the ashing rate increases, the activation energy decreases and the ground layer is never etched in the ashing process.

The above object is achieved by a method according to claim 1, whereby a reactant gas composed of at least three kinds of gases is applied to the ashing process. The reactant gas is composed of at least oxygen and hydrogen. As well known, oxygen is a main gas for performing the ashing, however hydrogen is for mainly decreasing the activation energy, increasing the ashing rate and avoiding the ground layer being etched in cooperation with another third gas respectively added to the reactant gas . The third gas added to the reactant gas is water vapor, nitrogen, nitrogen oxide or halogenide. The halogenide includes tetrafluoromethane (CF₄), chlorine(Cl₂), nitrogen trifluoride(NF₃), hexafluoroethane(C₂F₆) and trifluoromethane(CHF₃). The flow rate of the hydrogen and the third gas are controlled respectively.

The reactant gas including the third gas of nitrogen is discussed. According to the experiment by the inventors, the activation energy is decreased to 0.44 eV from 0.52 eV by adding hydrogen of more than 3%; wherein 0.52 eV is the activation energy corresponding to the oxygen. This is because of that the hydrogen acts to decrease the activation energy. The ashing rate of the reactant gas including the third gas of nitrogen is large as much as two or three times of that of the usual mixed gas of oxygen and nitrogen.

This mixed gas, described above, has three advantages of having a large ashing rate, having small activation energy and etching no ground layer in the fabrication process of the LSI or the VLSI.

### BRIEF DESCRIPTION OF THE DRAWINGS

Fig. 1 is a graph showing the variation of the ashing rate for resist in the case of using the reactant gas composed of O₂ and CF₄ with the flow ratio of CF₄ to the reactant gas, at 25°C ashing temperature.

Fig. 2 is a graph showing the variation of the ashing rate for resist in the case of using the reactant gas composed of O₂ and N₂ at 200°C ashing temperature and the variation of the concentration of oxygen atom in a down-flowed gas with the flow ratio of N₂ to the reactant gas.

Fig. 3 is a graph showing Arrhenius plots of the ashing rate for resist in the case of using the reactant gas composed of O₂ having 90% flow ratio, N₂ having 10% flow ratio and the reactant gas composed of oxygen.

Fig. 4 is a graph showing the variation of the ashing rate in the case of using the reactant gas composed of O₂ and H₂O at 180°C ashing temperature and the variation of the concentration of oxygen atom in a down-flowed gas with the flow ratio of H₂O to the reactant gas.

Fig. 5 is a graph showing Arrhenius plots of the ashing rate for in the case of using the reactant gas composed of O₂ having 60% flow ratio, H₂O having 40% flow ratio and he reactant gas composed of oxygen.

Fig. 6 is a graph showing the variation of the activation energy of the ashing using the reactant gas composed of O₂ and H₂O with the flow ratio of H₂O to the reactant gas.

Fig. 7 is a schematical drawing of a vacuum chamber of a down-flow ashing apparatus.

Fig. 8 is a graph showing Arrhenius plots of the ashing rate for resist in the case of using the reactant gas composed of O₂, H₂ and N₂, the reactant gas composed of O₂ and N₂ and the ractant gas composed of oxygen.

Fig. 9 is a graph showing the variations of the activation energy of the ashing using the reactant gas composed of O₂ and H₂O and the reactant gas composed of O₂ and H₂, with the flow ratio of H₂O to the reactant gas of O₂ and H₂O and with the flow ratio of H₂ to the reactant gas of O₂ and H₂ respectively.

### DESCRIPTION OF THE PREFERRED EMBODIMENT

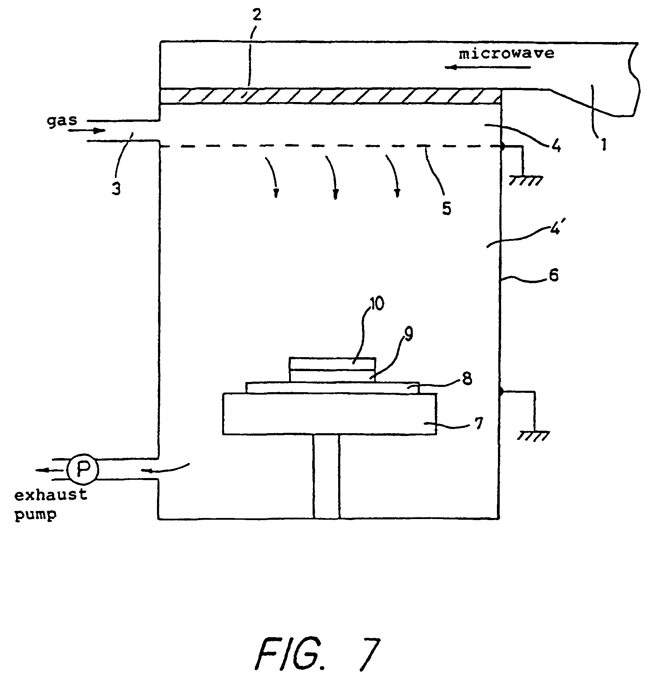

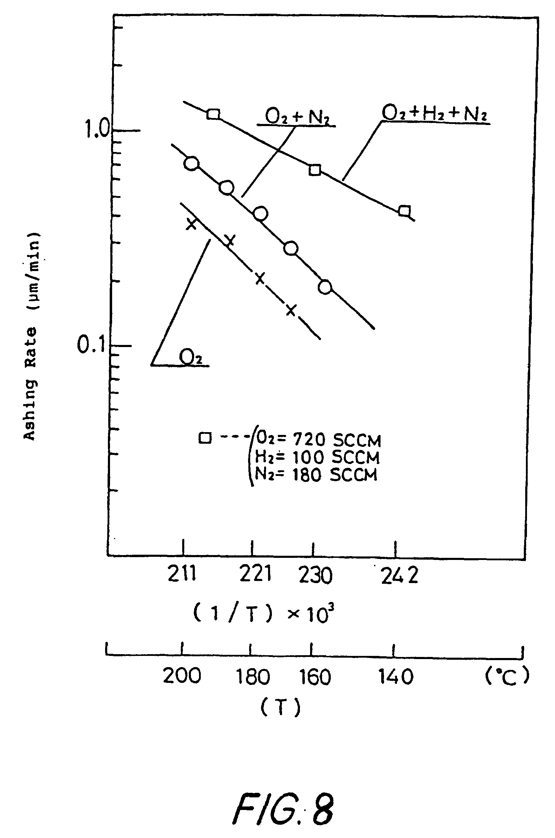

The plasma ashing methods of removing the resist, using reactant gas will be described in reference to Fig. 8. The plasma ashing is performed by a down flow ashing method using a conventional downstream microwave plasma resist stripper schematically shown in Fig. 7.

The preferred embodiment is the plasma ashing method using a reactant gas composed of O₂, H₂ and N₂. That is, the reactant gas composed of 720 SCCM O₂, 100 SCCM H₂ and 180 SCCM N₂ is applied to the down flow ashing process as described in the first embodiment.

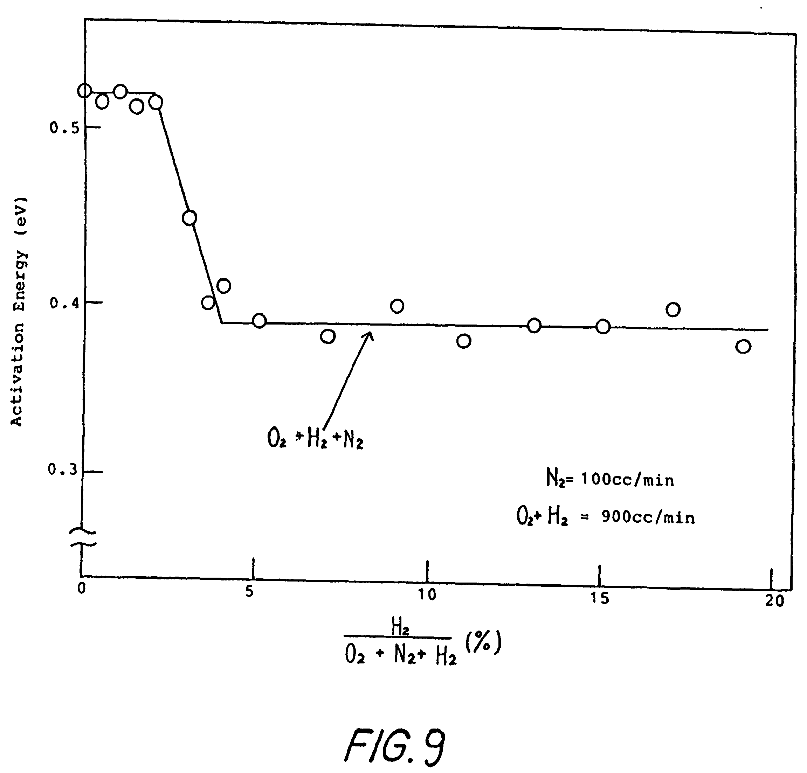

In the case of using the reactant gas composed of O₂, H₂ and N₂, the ashing rate is shown by a line connecting white squares in Fig. 12 represented in Arrhenius plot, and the activation energy is shown with the flow rate of H₂ to the reactant gas composed of O₂, H₂ and N₂ in Fig. 9.

In Fig. 8, the ashing rate in the case of using a reactant gas composed of only O₂ and that of using a reactant gas composed of O₂ and N₂ are also shown by a line connecting multiplication signs and a line connected white circles respectively, for the sake of the comparison with the reactant gas composed of O₂, H₂ and N₂. In the case of using the reactant gas composed of O₂, H₂ and N₂, the ashing rate is about 0.7 µm/min at 160°C of ashing temperature as shown in Fig. 8, and the activation energy is about 0.4 eV as shown in Fig. 9.

In Fig. 9, it is found that the activation energy rapidly decreases to a value of approximately 0.4 eV during the flow ratio is increased from 0% to approximately 5% and kept constantly in the value more or less than 0.4 eV in a region of the flow ratio beyond 5%. The plasma ashing is actually carried out in this constant region of the activation energy. In Fig. 9, it can be said that the characteristic of having the constant activation energy is very important for performing the plasma ashing in stable and precisely.

The flow rate of each component gas is set 720 SCCM, 100 SCCM and 180 SCCM for O₂, H₂ and N₂, respectively, as a desirable example. However, the flow rate of H₂ is not limited if the flow ratio of the H₂ the reactant gas is larger than 3%, because the activation energy of ashing in the case using the reactant gas is about o.4 eV regardless of the flow ratio, as seen in Fig. 9. The flow rate of N₂ is not limited if the flow ratio of N₂ to the mixed gas of O₂ and N₂ is larger than 5%, because the ashing rate is constant regardless of the flow ratio when the flow ratio exceeds 5%.

In the preferred embodiment, the plasma ashing is performed by using the reactant gas of O₂, H₂ and N₂. However, it was confirmed that H₂O, NOₓ or halogenide can be used instead of N₂.

The preferred embodiment described above is related to removing the resist film by plasma ashing, however the present invention can be applied to removing the organic polymer film.

Though the reactant gas described in the preferred embodiment is composed of three kinds of gases, an inert gas such as He, Ne or Ar can be added to the reactant gas up to 7%.

## Claims

1. An ashing method for removing an organic material formed on a ground substance of a semiconductor device (8), said method comprising the steps of:
providing plasma ashing means for performing the removement of the organic material by using a plasma of a reactant gas;
supplying as the reactant gas, a mixed gas consisting essentially of oxygen, hydrogen and an additional gas to said plasma ashing means;
generating plasma of the reactant gas for producing active species of the reactant gas; and removing the organic material by using the active species, leaving the ground substance,
**characterized by** further comprising the step of
controlling flow ratios of the oxygen, the hydrogen and said additional gas of said mixed gas for obtaining said reactant gas, wherein the flow of said hydrogen is larger than 1 % of the flow of the mixed gas.

2. A method according to claim 1,
**characterized in that**
said removing step is performed in down stream from the plasma.

3. A method according to claims 1 or 2,
**characterized in that**
said additional gas is selected from a group consisting of nitrogen and nitrogen oxide.

4. A method according to claim 3,
**characterized in that**
said flow ratios of the oxygen and of nitrogen selected as said additional gas of said mixed gas is controlled so that a flow ratio of the hydrogen to a gas composed of the oxygen, the hydrogen and the nitrogen is set so as to be more than 3 % and a flow ratio of the nitrogen to a gas composed of the oxygen and the nitrogen is set so as to be more than 5 %.

5. A method according to claim 4,
**characterized by** further comprising the step of
setting a temperature of the organic material at higher than 140 °C, so as to obtain an ashing rate larger than 0.5 µm/min.

6. A method according to claims 1 or 2,
**characterized in that**
said additional gas is selected from a halogenide group consisting of tetrafluoromethane, chlorine, nitrogen trifluoride, hexafluoroethane and trifluoromethane.

## Patentansprüche

1. Veraschungsverfahren zum Beseitigen von organischem Material, welches auf einer Grundsubstanz einer Halbleitereinrichtung (8) gebildet ist, wobei das Verfahren folgende Schritte aufweist:
Bereitstellen einer Plasma-Veraschungseinrichtung, um die Beseitigung des organischen Materials unter Verwendung eines Plasmas eines Reaktant-Gases durchzuführen;
Liefern eines Mischgases als Reaktant-Gas, welches im Wesentlichen aus Sauerstoff, Wasserstoff und einem Zusatzgas besteht, zur Plasma-Veraschungseinrichtung;
Erzeugen von Plasma des Reaktant-Gases zum Erzeugen von aktiven Arten des Reaktant-Gases; und
Beseitigen des organischen Materials unter Verwendung der aktiven Arten, wobei die Grundsubstanz belassen wird,
**dadurch gekennzeichnet, dass** dies außerdem folgenden Schritt aufweist:
Steuern von Flussverhältnissen des Sauerstoffs, des Wasserstoffs und des Zusatzgases des Mischgases, um das Reaktant-Gas zu erhalten, wobei der Fluss des Wasserstoffs größer ist als 1 % des Flusses des Mischgases.

2. Verfahren nach Anspruch 1,
**dadurch gekennzeichnet, dass**
der Beseitigungsschritt im Abwärtsstrom vom Plasma durchgeführt wird.

3. Verfahren nach Anspruch 1 oder 2,
**dadurch gekennzeichnet, dass**
das Zusatzgas aus einer Gruppe ausgewählt wird, die aus Stickstoff und Stickoxid besteht.

4. Verfahren nach Anspruch 3,
**dadurch gekennzeichnet, dass**
die Flussverhältnisse des Sauerstoffs und des Stickstoffs, die als Zusatzgas des Mischgases ausgewählt werden, so gesteuert werden, dass ein Flussverhältnis des Wasserstoffs zu einem Gas, welches aus dem Sauerstoff, dem Wasserstoff und dem Stickstoff besteht, so festgelegt ist, dass dies mehr als 3% ist, und ein Flussverhältnis des Stickstoffs zu einem Gas, welches aus dem Sauerstoff und dem Stickstoff zusammengesetzt ist, so festgelegt ist, dass dies mehr als 5% ist.

5. Verfahren nach Anspruch 4,
**dadurch gekennzeichnet, dass dieses außerdem den folgenden Schritt aufweist:**
Einstellen einer Temperatur des organischen Materials auf höher als 140°C, um damit eine Veraschungsrate zu erzielen, die größer ist als 0,5µm/min.

6. Verfahren nach Anspruch 1 oder 2,
**dadurch gekennzeichnet, dass**
das Zusatzgas aus einer Halogenid-Gruppe ausgewählt wird, welche aus Tetrafluormethan, Chlor, Stickstoff-Trifluorid, Hexafluorethan und Trifluormethan besteht.

## Revendications

1. Procédé d'incinération pour éliminer un matériau organique formé sur une substance de base d'un dispositif semi-conducteur (8), ledit procédé comprenant les étapes consistant :
- à fournir un moyen d'incinération au plasma pour réaliser l'élimination du matériau organique en utilisant un plasma d'un gaz de corps réagissant;
- à introduire dans ledit moyen d'incinération au plasma comme gaz de corps réagissant un gaz mixte essentiellement constitué d'oxygène, d'hydrogène et d'un gaz supplémentaire;
- à produire un plasma du gaz de corps réagissant pour produire des espèces actives du gaz de corps réagissant;
- et à éliminer le matériau organique en utilisant les espèces actives, laissant la substance de base,
**caractérisé en ce qu'**il comprend en outre l'étape consistant
- à régler les débits partiels de l'oxygène, de l'hydrogène et dudit gaz supplémentaire dudit gaz mixte pour obtenir ledit gaz de corps réagissant, dans lequel le débit dudit hydrogène est supérieur à 1% du débit du gaz mixte.

2. Procédé selon la revendication 1 **caractérisé en ce que** ladite étape d'élimination est réalisée à courant descendant à partir du plasma.

3. Procédé selon la revendication 1 ou 2 **caractérisé en ce que** ledit gaz supplémentaire est choisi parmi l'azote et l'oxyde d'azote.

4. Procédé selon la revendication 3 **caractérisé en ce que** lesdits débits partiels de l'oxygène et de l'azote choisi comme ledit gaz supplémentaire dudit gaz mixte sont réglés de telle sorte qu'un débit partiel de l'hydrogène d'un gaz constitué de l'oxygène, de l'hydrogène et de l'azote est fixé à au plus 3% et un débit partiel de l'azote d'un gaz constitué de l'oxygène et de l'azote est fixé à au plus 5%.

5. Procédé selon la revendication 4 **caractérisé en ce qu'**il comprend en outre l'étape consistant à fixer la température du matériau organique à une température supérieure à 140°C afin d'obtenir une vitesse d'incinération supérieure à 0,5 µm/min.

6. Procédé selon la revendication 1 ou 2 **caractérisé en ce que** ledit gaz supplémentaire est choisi dans un groupe d'halogénures constitué de tétrafluorométhane, de chlore, de trifluorure d'azote, d'hexafluoroéthane et de trifluorométhane.
